# EUROPEAN PATENT APPLICATION

(11) **EP 2 306 489 A1**
(43) Date of publication of application: **06.04.2011**
(21) Application number: 09172133.2
(22) Date of filing: 02.10.2009
(51) Int. Cl.: H01J 37/34

(54) **Method for coating a substrate and coater**

(71) Applicant: Applied Materials, Inc., Santa Clara, CA 95054 (US)
(72) Inventor: Bender, Markus, 63454, Hanau (DE); Hanika, Markus, 86899, Landsberg (DE); Scheer, Evelyn, 63811, Stockstadt (DE); Pieralisi, Fabio, 63739, Aschaffenburg (DE); Mahnke, Guido, 63814, Mainaschaff (DE)
(74) Representative: Zimmermann & Partner

(57) **Abstract**

A method is provided for coating substrates with at least one cathode assembly (10) having a rotatable target (20), the rotatable target being provided with at least one magnet assembly (25) positioned there within. The method includes providing a potential difference between the substrate and the rotatable target that is varied over time during coating. Further, the method may include positioning the magnet assembly (25) with respect to the rotatable target so that the magnet assembly is asymmetrically aligned with respect to a plane perpendicularly extending from the substrate to the axis of the rotatable target for a predetermined first time interval. The magnet assembly is then moved to a second position that is also asymmetrically aligned. Further, a coater for coating substrates is provided including a cathode assembly with a rotatable curved target and two magnet assemblies positioned within the rotatable curved target.

## Description

### FIELD OF THE INVENTION

The present disclosure relates to a method for coating a substrate and a coater for coating a substrate. More specifically, it relates to a method for coating a substrate and a coater for coating substrates, in particular by sputtering. More specifically, the present disclosure is directed at magnetron sputtering wherein the target is typically a rotatable target. Even more specifically, the method and the coater are directed at static sputtering deposition. The present disclosure particularly relates to substrate coating technology solutions involving equipment, processes and materials used in the deposition, patterning, and treatment of substrates and coatings, with representative examples including (but not limited to) applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nanomolding.

### BACKGROUND OF THE INVENTION

In many applications, it is desired to deposit a thin layer of a coating material on a substrate. Known techniques for depositing layers are particularly evaporating and sputtering.

Sputtering is a vacuum coating process used to deposit thin films of various materials onto the surface of a substrate. For example, sputtering can be used to deposit a metal layer such as a thin layer of aluminium or ceramics. During the sputtering process, the coating material is transported from a target consisting of that material to the substrate to be coated by bombarding the surface of the target with ions of an inert gas or reactive gas that are accelerated by a high voltage. When the gas ions hit the outer surface of the target, their momentum is transferred to the atoms of the material so that some of them can gain sufficient energy to overcome their bonding energy in order to escape from the target surface and to deposit on the substrate. Thereon, they form a film of the desired material. The thickness of the deposited film is, inter alia, dependent on the duration of exposing the substrate to the sputtering process.

It is an ongoing desire to further improve the quality of the deposited layers. It is desired to have a high homogeneity of the layer on the substrate when coating a substrate with a layer. In particular, it is desired that the thickness of the deposited layer on the substrate is as uniform as possible throughout the whole substrate. It is further desired to have a high degree of homogeneity in terms of characteristics such as the grown crystal structure, the specific resistance, and the stress of the layer. For instance, in the production of metalized layers the signal delay is dependent on the thickness of the layer so that, e.g., in the production of displays a varying thickness might result in pixels that are energized at slightly different times. It is further important to rely on a uniform layer thickness when etching a layer in order to achieve the same results at different positions.

In order to improve these characteristics of a deposited layer, it has been proposed to wiggle the magnets within a rotatable target during sputtering. In other words, it has been suggested that the magnet of a magnetron sputter cathode is constantly moved with constant angular velocity in between certain maximum outer positions around the zero-position.

It turns out, however, that this results in a homogeneity that can still be improved.

### SUMMARY OF THE INVENTION

In view of the above, a method for coating a substrate and a coater for coating a substrate is provided.

According to one aspect, a method for coating a substrate with at least one cathode assembly having a rotatable target is provided. The rotatable target is provided with at least one magnet assembly positioned in the rotatable target. The method includes providing a voltage to the rotatable target that is varied over time during the coating.

According to another aspect, a a method for coating a substrate with at least one cathode assembly having a rotatable target is provided. The rotatable target has at least one magnet assembly positioned in the rotatable target. The method includes positioning the magnet assembly with respect to the rotatable target at a first position so that the magnet assembly is asymmetrically aligned with respect to a plane perpendicularly extending from the substrate to the axis of the rotatable target for a predetermined first time interval. The method further includes moving the magnet assembly to a second position that is also asymmetrically aligned with respect to this plane.

According to another aspect, a coater for coating substrates is provided with at least one cathode assembly having a rotatable curved target; and two magnet assemblies positioned within the rotatable curved target of the at least one cathode assembly.

Further aspects, details, advantage and features are apparent from the dependent claims, the description and the accompanying drawings.

Embodiments are also directed to apparatuses for carrying out each of the disclosed methods and including apparatus parts for performing each described method step. These method steps may be performed by way of hardware components, a computer program by appropriate software, by any combination of the two or in any other manner. Furthermore, embodiments are also directed to methods by which the described apparatus operates or by which the described apparatus is manufactured. It includes method steps for carrying out functions of this apparatus or manufacturing parts of the apparatus.

### BRIEF DESCRIPTION OF THE DRAWINGS

Some of the above indicated in other more detailed aspects of the invention will be described in the following description and partially illustrated with reference to the figures. Therein:
Fig. 1, 2, 3a, 3b and 4 are schematic cross sectional views of a coater illustrating the method for coating a substrate according to embodiments described herein;
Fig. 5 is a schematic cross sectional view of a coater according to embodiments described herein;
Fig. 6 is a schematic diagram showing the relation between the angular position of the magnet assemblies and the uniformity of the deposited layer according to embodiments described herein;
Fig. 7 is a schematic diagram showing the relation between the ratio of waiting time to overall coating time and the uniformity of the deposited layer according to embodiments described herein; and
Fig. 8 is a schematic diagram showing exemplarily a square wave voltage applied to the cathode assembly according to embodiments described herein.
Fig. 9 is a schematic diagram showing exemplarily a sine voltage applied to the cathode assembly according to embodiments described herein.
Fig. 10 is a schematic cross sectional view of an array of cathode assemblies positioned for coating a substrate.

### DETAILED DESCRIPTION OF THE DRAWINGS

Within the following description of the drawings, the same reference numbers refer to the same components. Generally, only the differences with respect to the individual embodiments are described.

The process of coating a substrate with a material as described herein refers typically to thin-film applications. The term "coating" and the term "depositing" are used synonymously herein. The typical coating process used in embodiments described herein is sputtering. Generally, sputtering can be undertaken as diode sputtering or magnetron sputtering. The magnetron sputtering is particularly advantageous in that its deposition rates are rather high. Typically, a magnet is positioned within the rotatable target. By arranging the magnet or the magnets behind the target, i.e. inside of the target in the event of a rotatable target, in order to trap the free electrons within the generated magnetic field, which is generated directly below the target surface, these electrons are forced to move within the magnetic field and cannot escape. This enhances the probability of ionizing the gas molecules typically by several orders of magnitude. This, in turn, increases the deposition rate magnificently.

The substrate may be continuously moved during coating ("dynamic coating") or the substrate to be coated rests during coating ("static coating"). Static coating is advantageous in that the amount of target material used up for the coating is smaller in comparison to dynamic coating since in the latter case the substrate holders are often coated as well. Static coating particularly allows the coating of large-area substrates. The substrates are entered into a coating area, the coating is performed, and the substrates are taken out of the coating area again.

Sputtering can be used in the production of displays. In more detail, sputtering may be used for the metallization such as the generation of electrodes or buses. It is also used for the generation of thin film transistors (TFTs). It may also be used for the generation of the ITO (indium tin oxide) layer.

Sputtering can also be used in the production of thin-film solar cells. Generally, a thin-film solar cell comprises a back contact, an absorbing layer, and a transparent and conductive oxide layer (TCO). Typically, the back contact and the TCO layer is produced by sputtering whereas the absorbing layer is typically made in a chemical vapour deposition process.

In comparison to an evaporation process such as chemical vapour deposition, sputtering is advantageous in that also materials can be sputtered that cannot be evaporated. Further, the adhesion of the produced layers to the substrate is typically stronger in sputtering processes than in evaporation processes. Further, sputtering is a directional process so that the major part of the material is transferred to the substrate and does therefore not coat the interior of the deposition apparatus (as in evaporation applications).

The term "substrate" as used herein shall embrace both inflexible substrates, e.g., a wafer or a glass plate, and flexible substrates such as webs and foils. Typically, the present disclosure is directed at static coating. In most cases, the substrate is an inflexible substrate such as a glass plate, e.g., used in the production of solar cells. The term "coating" shall particularly include sputtering. Accordingly, the coater as described herein is typically a sputter apparatus and the cathode assembly is a sputter cathode.

The term "magnet assembly" as used is a unit capable of a generating a magnetic field. Typically, the magnet assembly consists of a permanent magnet. This permanent magnet is typically arranged within the rotatable target such that the free electrons are trapped within the generated magnetic field generated below the rotatable target surface. In many embodiments, the magnet assembly comprises a magnet yoke. According to an aspect, the magnet assembly is generally movable within the rotatable tube. By moving the magnet assembly, more particularly by rotating the magnet assembly along the axis of the rotatable tube as rotation center, the sputtered material can be directed in different directions.

According to an aspect of the present disclosure, the voltage applied to the rotatable target is varied over time. That is, a non-constant voltage is applied to the rotatable target. Typically, the sputter power is changed depending on the magnet assembly position. One should note that the sputter power is normally directly corresponding to the voltage applied to the rotatable target. Apart from values of close to 0V, the relation between applied voltage and sputter power is linear in a first approximation. Therefore, one way of putting it is that the sputter power is varied over time.

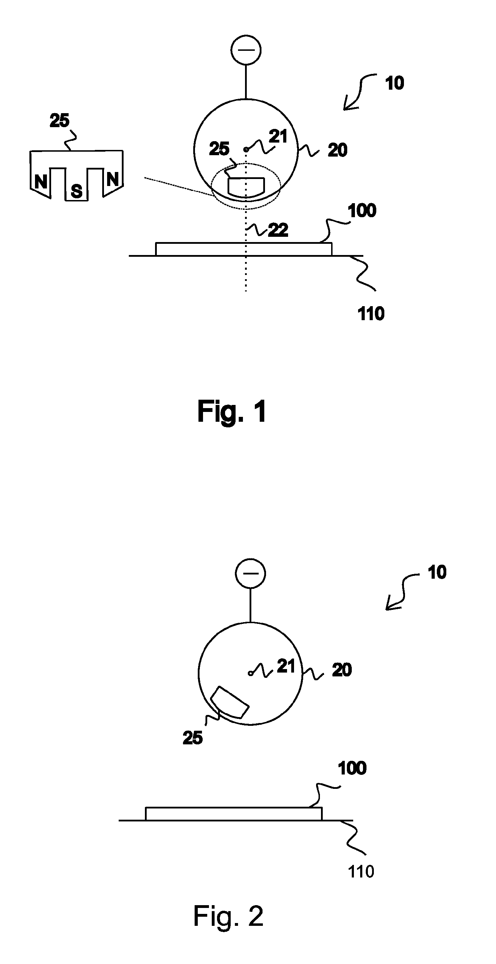

Fig. 1 schematically illustrates a substrate 100 being positioned on a substrate holder 110. The rotatable target 20 of the cathode assembly 10 is positioned over the substrate 100. A negative potential is applied to the rotatable target. A magnet assembly 25 is schematically shown located within the rotatable target 20. In many embodiments, an anode (not shown in Fig. 1), which a positive potential is applied to, is positioned close to the rotatable target. Such an anode may have the shape of a bar, with the bar's axis being typically arranged in parallel to the axis of the angular tube. In other embodiments, a separate bias voltage may be applied to the substrate. "Positioning the magnet assembly" as used herein is generally to be understood as operating the coater with the magnet assembly located at a certain constant position.

A typical permanent magnet as used in embodiments described herein has a two north magnetic poles and a south magnet pole. These poles refer each to a surface of the magnet assembly. The surfaces typically face the rotatable target from its inside.

In many cases, one pole is positioned in the middle whereas two opposite poles are arranged adjacent to it. In Fig. 1, an enlargement of the magnet assembly 25 is shown for illustrating such a situation. As shown, the south pole is positioned in the middle, whereas the north poles enframe the south poles. The pole surfaces' shape may be adapted to the curvature of the rotatable curved target they are positioned in. In many embodiments, the surface of each pole defines a plane. The planes of the magnet poles are normally not parallel. However, the plane defined by the surface of the pole arranged in the middle has an orientation that is typically exactly in the middle of the orientations of the planes defined by the poles of the outer magnet poles. In more mathematical terms, the added vertical vectorial components of the outer pole surfaces sum up exactly to the vertical vectorial component of the inner pole surface.

The term "vertical" in this explanation refers to the vertical orientation as shown in Fig. 1. In more general terms, the term "vertical" refers to the orientation of the substrate. That is, the phrase "the magnet assembly is positioned at a non-zero position" describes a situation wherein a mean surface defined as the vectorial sum of all pole surfaces of the magnet assembly has an orientation that differs from the orientation of the substrate surface.

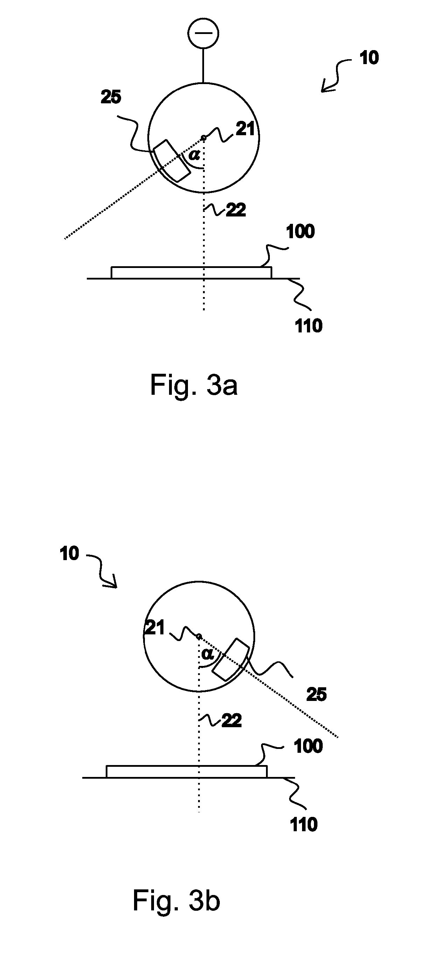

The substrate's surface defines a plane that is horizontally arranged in the figures shown. One can generally think of a plane perpendicularly extending from the substrate to the axis of the rotatable target. In many embodiments, this plane is also perpendicular to the substrate holder. This plane shall be called the "substrate-target interconnection plane" herein. In Figs. 1, 3a and 3b, this plane is exemplarily shown as the vertically arranged dotted line 22.

Although the embodiments shown in the figures illustrate the rotatable target to be arranged above a horizontally arranged substrate and the definition of the substrate-target interconnection plane was illustratively explained with respect to those embodiments, it shall be mentioned that the orientation of the substrate in space can also be vertical. In particular, in view of large-area coating, it might simplify and ease transportation and handling of a substrate if it is oriented vertically. In other embodiments, it is even possible to arrange the substrate somewhere between a horizontal and a vertical orientation.

According to an aspect of the present disclosure, the magnet assembly is asymmetrically aligned with respect to the substrate-target interconnection plane for a predetermined time interval. It shall be noted that the phrase "positioning the magnet assembly asymmetrically aligned for some time" shall be understood as positioning the magnet assembly asymmetrically and keeping it at exactly this position for some time. Typically, this predetermined time interval is larger than 0.1 sec, more typically 1 sec, more typically larger than 10 sec, and even more typically larger than 30 sec.

Typically, the rotatable curved target has the shape of a cylinder. In order to specify the angular position of elements such as the magnet assembly within the cylinder, one can refer to cylindrical coordinates. Given the particular interest in the angular position, within the present disclosure, the angle is used for the indication of the position. Within the present disclosure, the zero angle position shall be defined as the position within the rotatable target that is closest to the substrate. The zero angle position therefore typically lies within the direct substrate target connection plane 22.

According to aspects of the present disclosure, the magnet assembly is positioned at a non-zero angle position within the rotatable target for a predetermined time interval. This is what is illustrated in Fig. 2. More specifically, it is also shown in Fig. 3a where the magnet assembly 25 is positioned at an angle of -α with respect to the zero angle position. The magnet assembly is then moved to a second non-zero angle position. Fig. 3b illustrates embodiments where the magnet assembly is positioned at an angle of +α with respect to the zero angle position for a predetermined time interval. A negative angle shall refer to a deflection to the left whereas a positive angle shall refer to a deflection to the right as described herein.

Positioning the magnet assembly at a non-zero angle position, i.e., asymmetrically aligned with the substrate-target interconnection plane, results in that the plasma is generated not at that area over the target surface that is closest to the substrate but at an area arranged laterally. Thus, the sputter variance is increased so that such a tilted position of the magnet assembly may result in a higher coating rate of areas that are not supposed to be coated such as the substrate holder or walls within the coating room. In other words, it may thus result in a reduced efficiency.

Despite this situation, it has been surprisingly found out by the inventors of the present disclosure that the homogeneity of the deposited layer on the substrate could be increased by positioning the magnets asymmetrically aligned with the direct substrate target connection plane. When talking about the homogeneity of the layer, this shall be mainly understood as the uniformity of the layer thickness throughout the coated area on the substrate, the crystal structure, the specific resistance, and the stress of the layer.

According to an aspect, when coating a substrate, the magnet assembly is positioned at a first non-zero angle position for a first predetermined time interval. It is then moved to a second non-zero angle position and kept there for a second predetermined time interval. Typically, the first predetermined time interval, i.e., the time interval during which the magnet assembly is kept at a first non-zero angle position, and the second time interval, i.e. the time interval the magnet assembly is positioned at a second non-zero angle position, are identical. Further, according to embodiments, the absolute value of the angle of the first position and the second position is identical. Typically, the second position corresponds to the first position mirrored at the direct substrate target connection plane.

This situation is schematically shown in the Figs. 3a and 3b, wherein the magnet assembly 25 is positioned in a first position in the embodiments of Fig. 3a, i.e., at an angle of -α to the direct substrate target connection plane. In Fig. 3b, the magnet assembly 25 is positioned at a second position defined at an angle α with respect to the direct substrate target connection plane. The illustration of the voltage is shown only in some of the figures for an increased clarity of the figures. However, it shall be understood that, in operation, a negative voltage is typically applied to the cathode assembly.

It has been found out that the uniformity can be further increased if the electrical field is switched off at times where the magnet is moved. This is surprising, since it had been proposed in the prior art to sputter during a constantly moving magnet that wobbles between the left and right maximum angles. Despite this teaching, the inventors have found out that the homogeneity can be increased if sputtering is paused at those times where the magnet assembly is neither located at a first position nor at a second position.

In many embodiments, the optimum homogeneity can be achieved when the electrical field is switched on when the magnets are at outer positions such as at angles of at least 15° or even 25°. Typically, the magnet assembly is waiting at the outer positions for some time. Typically, the electrical voltage is only switched on when the magnet assembly is at the outer positions. During movement of the magnet assembly the discharge is interrupted, i.e., the electrical potential difference between cathode assembly and anode is kept close to zero.

Consequently, according to embodiments, it is proposed to coat the substrate by sputtering in the following way: The magnet assembly is positioned at a first non-zero angle position within the rotatable target and kept there for a first time interval with the electrical field for sputtering being switched on. For instance, the magnet assembly may be positioned at the angle α. Second, after the first time interval has lapsed, the magnet assembly is moved to the second non-zero angle position, thereby typically passing the zero angle position. During movement the electrical field is switched off. Third, the magnet assembly is kept at a second non-zero angle position for a second time interval with the electrical field being switched on again. The phrase "the electrical field being switched on" is understood as that a voltage is applied to the cathode assembly and the anode.

According to embodiments, the voltage applied is constant during the first time interval and/or the second time interval. The voltage applied is typically equal at those times where the magnet assembly is at the first position and at those times where the magnet assembly is at the second position.

According to typical embodiments, positioning the magnet assembly asymmetrically aligned with the substrate target interconnection plane is undertaken at angles of between 15° and 45°, more typically between 15° and 35° with respect to the zero angle position. In some experiments, it turned out that angles close to 30° result in the best homogeneity of the deposited layer. These exemplary angle values are, of course, understood as absolute values of the angle.

As already set forth, it is typical to position the magnet assembly in a first and a second position wherein the second position has the identical absolute value of the angle but mirrored at the substrate-target interconnection plane.

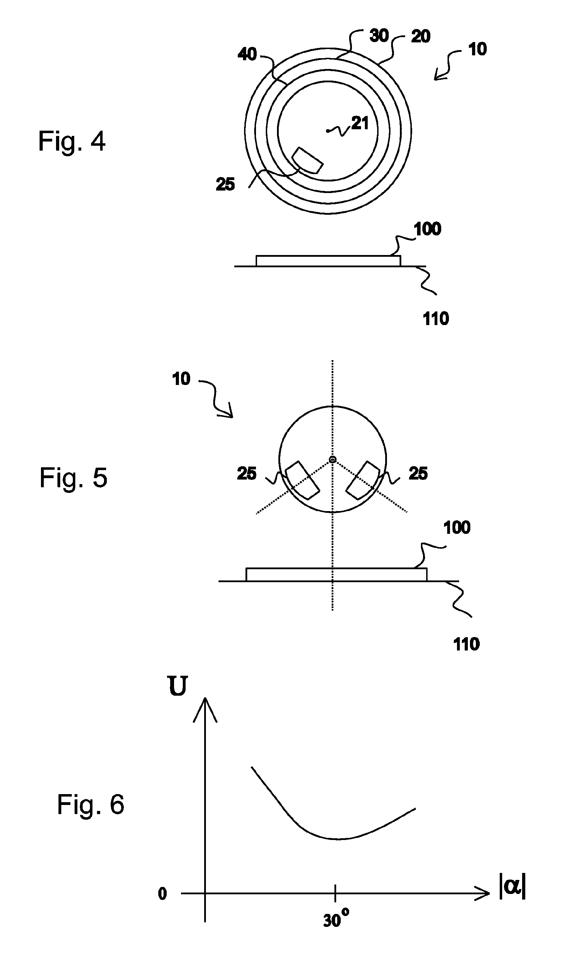

Fig. 4 exemplarily illustrates a cathode assembly as used in embodiments described herein in more detail. It is to be understood that all the elements shown in Fig. 4 may also be applied in other embodiments described herein, in particular in those embodiment described with respect to Figs. 1, 2, 3a, 3b, and 5. What is shown in Fig. 4 is that the rotatable target 20 can be placed on a backing tube. The backing tube is mainly for mounting the rotatable target the material of which is supposed to be cleared away during sputtering. In order to reduce the high temperatures on the target that result from the sputtering process, in many embodiments the rotatable target is aligned with a cooling material tube 40 in its inside. Typically, water is used as cooling material. Cooling is necessary because the major part of the energy put into the sputtering process - typically in the order of magnitude of some kilo Watts - is transferred into heat of the target. As shown in the schematic view of Fig. 4, the magnet assembly is positioned within the backing tube and the cooling material tube so that it can move therein to different angle positions if desired. According to other embodiments, the complete inner part of the target tube is filled with cooling material such as water.

Generally, and not limited to the embodiment of Fig. 4, the magnet assembly may be mounted on the axis of the target tube. A pivoting movement as described herein may be caused by an electromotor providing the necessary rotational force. In typical embodiments, the cathode assembly is equipped with two shafts: A first shaft which the rotatable target tube is mounted on. The first shaft is rotated in operation of the cathode assembly. The movable magnet assembly is typically mounted to the second shaft. The second shaft moves independently from the first shaft, typically in a manner so as to allow the movement of the magnet assembly as described herein.

Fig. 5 shows exemplarily an aspect of the present disclosure with the rotatable curved tube including two magnet assemblies 25. Typically, both magnet assemblies are positioned asymmetrically aligned with respect to the substrate target interconnection plane, i.e., they are positioned at non-zero angle positions. Further, typically, the angle of their position with respect to the zero-angle position is identical with respect to its absolute value.

In comparison to the provision of only one magnet assembly per target tube, this configuration allows that two plasmas are generated in front of the target surface adjacent to both magnet assemblies. The sputtering efficiency can thus be increased. Further, by positioning the two magnet assemblies at non-zero angle positions this configuration can benefit from the increased uniformity that could have been observed when positioning the magnet assemblies at non-zero angle positions for predetermined time intervals during operation of the coater.

Typically, the two magnets are positioned at absolute angle values between 15° and 45°, more typically at between 25° and 35° with respect to the zero angle position. Typically, the absolute angle value of both magnet assemblies with respect to the zero angle position is identical. It is possible to constantly arrange the two magnets at their respective positions. According to embodiments, the second magnet assembly is positioned at a position that refers to the position of the first magnet assembly mirrored at the substrate-target interconnection plane.

Within the present disclosure, the figures illustrate cross sectional schematic views of coaters along with exemplarily shown substrates. Typically, the cathode assemblies 10 comprise the rotatable target which has the shape of a cylinder. In other words, the target extends into the paper and out of the paper when looking at the drawings. The same is true with respect to the magnet assemblies that are also only schematically shown as cross sectional elements. Generally, it is intended that the magnet assemblies extend along the complete length of the cylinder. For technical reasons, it is typical that they extend at least 80 % of the cylinder length, more typically at least 90 % of the cylinder length.

Fig. 6 is a schematic diagram showing the relation between the uniformity U of the deposited layer in dependence on the absolute value of the angle α at which the magnet assembly/assemblies is/are positioned within the rotatable tube. The inventors measured that the curved line representing the uniformity of the deposited layer in terms of deviations from the desired thickness drops up to the angle value of about 30°. The diagram of Fig. 6 further shows that the homogeneity starts to decrease again if the absolute value of the angle α is further increased. Hence, it is typical according to embodiments described herein to adjust the magnet assemblies in the range between about 20° and 40°, more typically between 25° and 35°.

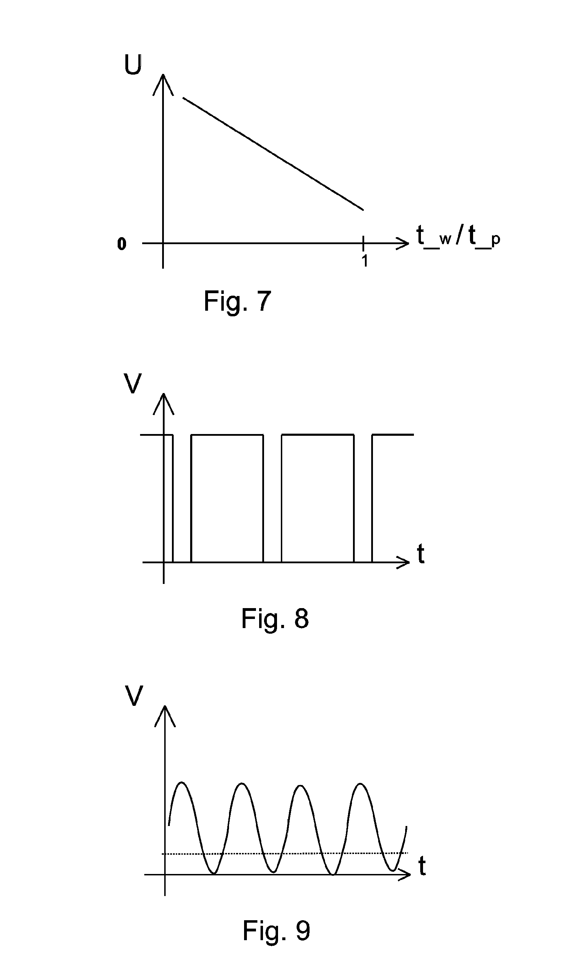

The shown unit "U" refers to the uniformity of the layer measured in percentile variations from the desired layer thickness. At the crossing with the α-axis, the percentage is zero. Although this is of course desirable from a theoretical viewpoint, values like that are hardly reachable. Nonetheless, the present disclosure allows reaching a uniformity of below 3 %, in some embodiments a percentage value even in the range of 2 %. The measured results as shown in Figs. 6 and 7 were measured at a sputtering process of pure copper with a power of about 17.5 kW/meter and a pressure value of about 0.5 Pascal. The substrates that were coated are large area substrates.

Generally, the present disclosure is particularly directed at large area substrate coatings. Typically, a multitude of cathode assemblies each having a rotatable curved target are provided for coating the large area substrates. The room adapted for coating a substrate shall be called "coating room". Typically, each coating room is adapted for coating one substrate at one point in time. A multitude of substrates can be coated one after the other.

In many embodiments, the multitude of cathode assemblies is arranged in an array of cathode assemblies. In particular, for static large-area substrate deposition, it is typical to provide a one-dimensional array of cathode assemblies that are regularly arranged. Typically, the number of cathode assemblies is between 2 and 20, more typically between 9 and 16 per coating room.

In typical embodiments, the cathode assemblies are spaced apart from each other equidistantly. It is further typical that the length of the rotatable target is slightly larger than the length of the substrate to be coated. Additionally or alternatively, the cathode array may be slightly broader than the width of the substrate. "Slightly" typically includes a range of between 100% and 110%. The provision of a slightly larger coating length/width helps avoiding boundary effects. Normally, the cathode assemblies are located equidistantly away from the substrate.

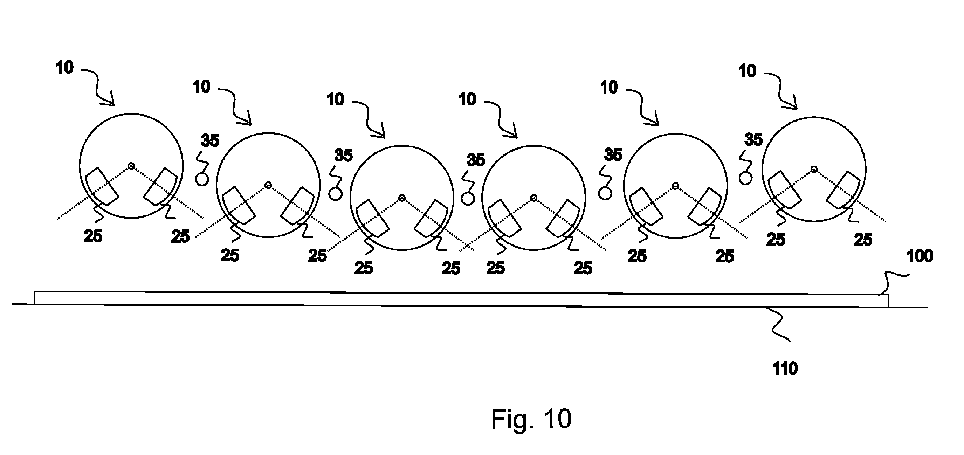

In embodiments, the multitude of cathode assemblies is arranged not in an equidistant fashion with respect to the substrate but along an arc's shape. The shape of the arc may be such that the inner cathode assemblies are located closer to the substrate than the outer cathode assemblies. Such a situation is schematically shown in Fig. 10. Alternatively, it is also possible that the shape of the arc defining the positions of the multitude of cathode assemblies is such that the outer cathode assemblies are located closer to the substrate than the inner cathode assemblies. The scattering behaviour depends on the material to be sputtered. Hence, depending on the application, i.e. on the material to be sputtered, providing the cathode assemblies on an arc shape will further increase the homogeneity. The orientation of the arc depends on the application.

In addition, Fig. 10 shows exemplarily anode bars positioned between the cathode assemblies that may be used in some of the embodiments described herein.

According to array embodiments, the respective magnet assemblies in each rotatable target tube are moved from the first position to the second position synchronously. A synchronous movement further increases the homogeneity of the layer.

Further, in array embodiments the angle of the first and second position of the multiple rotatable targets may be identical. It is also possible, however, that the angles differ with respect to different rotatable targets. More particularly, they may differ in dependence on the position of the cathode assembly with respect to the substrate. For example, it is possible that the angles the magnet assemblies are moved to in outer cathode assemblies are larger or smaller than the angles the magnet assemblies of the inner cathode assemblies are moved to. By making use of this method of operation, it may be possibly to further enhance the effect of the arc arrangement or, in case the cathode assemblies are positioned equidistantly away from the substrate, to simulate arc positioning.

Generally, the term "large area substrates" include substrates with a size of at least 1500 mm x 1800 mm.

Fig. 7 shows a further schematic diagram of the uniformity in dependence of the ratio between t_w and t_p. The time "t_w" represents the overall time at which the magnet assembly is positioned asymmetrically aligned with the substrate-target interconnection plane at a constant angle of larger than 15° such as at an angle of, e.g., 30°. In more detail, the magnet assembly was positioned at the first non-zero angle position for the first time interval and positioned at the second non-zero angle position for the second time interval after being moved to this position.

The time "t_p" is the overall process time of the coating. Hence, at the overall time t_p-t_w the magnet assembly is moved from the first non-zero angle position to the second non-zero angle position with the electrical potential being constant during the complete overall process time t_p. In other terms, this diagram shows how much the uniformity of the substrate improves in dependence on how long the magnet assembly is positioned at a first and/or second non-zero angle position, i.e., asymmetrically aligned with the direct substrate target connection plane. As it can be recognized in the figures, it was found out by the inventors that the longer the magnet assembly is located at the first and second non-zero angle position in relation to the overall process time, the better the homogeneity and, in particular, the uniformity gets.

Therefore, the maximum homogeneity can be achieved by off zero-angle position sputtering. As stated, this can be achieved by arranging two magnets within the rotatable target with typically both magnet assemblies being positioned at a non-zero angle position. It can also be achieved by using only one magnet assembly that is positioned at a first non-zero angle position for some time. This magnet assembly can be moved within the rotatable target to a second non-zero angle position that is typically mirrored to the first non-zero angle position. Normally, it stays there for a second time interval.

According to embodiments, this movement is undertaken at a high speed so that the overall movement time is in the range of below 1 sec, more typically below 0.5 sec. It is further possible to switch off the voltage applied to the target at the time of movement which will further increase the uniformity, as is evident from the diagram of Fig. 7.

Fig. 8 shows the voltage V applied between a substrate and the target for those embodiments were the voltage is non-constant in time but has the shape of a square wave. As it can be seen in the figure, the voltage remains at a certain constant level for some time which is typically the first or the second time interval during sputtering where the magnet assembly is at a constant position. The voltage is then substantially reduced in certain time intervals. These time intervals typically refer to those times where the magnet assembly is moved within the rotatable target, e.g., from the first non-zero angle position to the second position.

According to embodiments, the voltage may be 0 V at those times when it is substantially reduced. Sputtering stops instantly. According to other embodiments, the voltage may be reduced to a certain threshold value that is a kind of initial voltage for the sputtering process. For instance, this threshold voltage may stop sputtering but may allow an easier restart of the sputter process. Typically however, the voltage is reduced to a value of less than 10 % of the sputter voltage, more typically of less than 5 % of the sputter voltage at those times where the magnet assembly moves.

Generally, it is possible to apply a potential having different shapes. Typically, however, the potential applied is synchronized with the positioning of the magnet assembly. For instance, the potential could drop during movement of the magnet assembly to a value of maximally 35%, more typically maximally 20% of the maximum potential value. For instance, Fig. 9 shows a potential having a sine shape. One could think of an embodiment wherein the magnet assembly is located at constant positions at those times wherein the potential is larger than the dotted line shown in Fig. 9. More plainly, during the coating the magnet assemblies located within the rotatable targets are pivoted from one side to the other side with the sputtering power being varied over the time in dependence on the angular position of the magnet assemblies.

According to embodiments, the magnet assembly is only moved once per substrate. That is, when coating a substrate, the magnet assembly is located at each first and second position only one time. In other embodiments, the magnet assembly may be moved several times. For instance, it may be moved three times so that, when coating a substrate, the magnet assembly is located at each first and second position two times. Although this might increase the overall process time because of the movements and the possible switch off of the sputter power during the movement, it might also further increase the homogeneity of the deposited layer.

Generally, the method and coater as disclosed herein can be used for depositing material on substrates. More particularly, they allow a high uniformity of the deposited layer and can therefore be used in the production of displays such as flat panel displays, e.g., TFTs. It may also be used in the production of solar cells, in particular of thin-film solar cells. Given the improved uniformity, as a further effect thereof, the overall material consumption can be reduced which is particularly desirable when using expensive materials. For instance, the proposed method and coater could be used for the deposition of an indium tin oxide (ITO) layer in the production of a flat panel display or a thin film solar cell.

While the foregoing is directed to embodiments of the invention, other and further embodiments of the invention may be devised without departing from the basic scope thereof, and the scope thereof is determined by the claims that follow.

This written description uses examples to disclose the invention, including the best mode, and also to enable any person skilled in the art to make and use the invention. While the invention has been described in terms of various specific embodiments, those skilled in the art will recognize that the invention can be practiced with modification within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A method for coating a substrate (100) with at least one cathode assembly (10) having a rotatable target (20), the rotatable target being provided with at least one magnet assembly (25) positioned there within, the method comprising
- providing a voltage to the rotatable target that is varied over time during the coating.

2. The method according to claim 1, further comprising positioning the substrate with respect to the rotatable target so that the magnet assembly is asymmetrically aligned with respect to a plane (22) perpendicularly extending from the substrate to the axis (21) of the rotatable target.

3. The method according to claim 2, wherein the magnet assembly is asymmetrically aligned for a predetermined first time interval.

4. The method according to claim 3, wherein the predetermined first time interval is at least 0.1 sec, preferably at least 1 sec.

5. The method according to any of the preceding claims further comprising
- moving the magnet assembly (25) within the rotatable target (20), preferably pivoting the magnet assembly (25) within the rotatable target.

6. The method according to any of the preceding claims wherein the voltage that is varied over time has a square waveform.

7. A method for coating a substrate (100) with at least one cathode assembly (10) having a rotatable target (20), the rotatable target having at least one magnet assembly (25) positioned there within, the method comprising
- positioning the magnet assembly with respect to the rotatable target at a first position so that the magnet assembly is asymmetrically aligned with respect to a plane (22) perpendicularly extending from the substrate (100) to the axis (21) of the rotatable target for a predetermined first time interval; and
- moving the magnet assembly to a second position that is also asymmetrically aligned with respect to said plane (22).

8. The method according to claim 7 wherein the at least one magnet assembly is positioned asymmetrically aligned for at least 80%, preferably at least 95% of the overall coating time.

9. The method according to claim 7 or 8, wherein said plane defines the zero angle position within the rotatable target with the magnet assembly (25) being positioned at an angle of between 15° and 45°, preferably between 25° and 35°.

10. The method according to claim 7, 8 or 9, further comprising
- providing a voltage to the rotatable target that is varied over time during coating.

11. The method according to any of claims 7 to 10, further comprising
- moving the at least one magnet assembly from the first position to the second position with the potential being substantially zero during movement of the magnet assembly from the first position to the second position.

12. The method according to any of claims 7-11, further comprising
- positioning the at least one magnet assembly at the second position for a predetermined second time interval.

13. The method according to claim 12, wherein the predetermined first time interval and the predetermined second time interval are identical.

14. A coater for coating substrates comprising
- at least one cathode assembly (10) having a rotatable curved target (25); and
- two magnet assemblies (25) positioned within the rotatable curved target of the at least one cathode assembly.

15. The coater according to claim 14 wherein the two magnet assemblies are away from each other at an angle of between 45° and 75°, preferably between 55° and 65°.
